# EUROPEAN PATENT APPLICATION

(11) **EP 2 924 447 A1**
(43) Date of publication of application: **30.09.2015**
(21) Application number: 15159293.8
(22) Date of filing: 16.03.2015
(51) Int. Cl.: G01R 1/20, G01R 15/18

(54) **COMBINED CURRENT SENSOR**

(30) Priority: 20.03.2014 GB 201405014
(71) Applicant: C&S Technology Ltd., Llandulas Abergele LL22 8JD (GB)
(72) Inventor: Ganley, Sean Christopher, Abergele, Conwy LL22 8JD (GB); Lewis, Carl Justin, Conwy LL32 8YY (GB)
(74) Representative: Palmer, Nicholas James

(57) **Abstract**

A device for measuring AC and DC current in an electrical network, the device comprising: a current transformer (78), and a resistive shunt (70) connected in series with a line in conductor or a line out conductor, the resistive shunt (70) being located on the current transformer (78) or current transformer case (75).

## Description

Embodiments of this invention relate to combined current sensors, and in particular to combined current sensors for use with circuit protection and control devices.

Circuit protection and control devices are typically used for the protection of electrical circuits to reduce the risk of - for example - electrocution, fire, and/or equipment damage in relation to those circuits and also to control the circuit typically by manually switching the circuit protection and control device to open or close main contacts thus making or breaking the circuit.

An example of a conventional circuit protection device is a residual current device which compares the current delivered to a load with the current returned from the load to determine if there is an imbalance and, hence, a leakage of current to earth. This is typically achieved by passing the main electrical supply conductors of the circuit (e.g. the live and neutral conductors) through the core of a transformer and using a secondary winding of the transformer to detect any differential current which is induced in the secondary winding (the effect of the current passing through the conductors otherwise cancelling each other out in normal conditions).

A further example of a conventional circuit protection and control device is a circuit breaker which protects the circuit from over current and short circuit fault conditions, typically using a bimetal senor and a solenoid actuator. The bimetal sensor, connected in series with the electrical circuit, heats up with the flow of current and deforms to trigger a mechanism to open a contact set to break the circuit. In the solenoid actuator, a solenoid primary winding of the circuit breaker is also connected in series with the circuit; therefore, in a gross over current or short circuit fault condition the high current generates sufficient magnetic flux to drive the solenoid plunger to trigger a mechanism to open a contact set to break the circuit.

It is also known to provide a resistive shunt (a member of known resistance) in series with one or more conductors in order to measure a voltage drop across the resistive shunt and, therefore, calculate the current passing there through. Low resistance resistive shunts are typically used in power meters; due to the resistive shunt having a low temperature coefficient of resistance, a stable resistance to can be maintained over a wide temperature range to provide accurate and stable current (and therefore power) measurement.

A circuit protection and control device typically includes or is coupled to a mechanism which is linked to a contact set for breaking the electrical circuit with a view to terminating an earth leakage, a short circuit, an over current, an over voltage, an under voltage, a series arc fault, or a parallel arc fault condition.

An emerging classification of device within the circuit protection and control industry is a device having combined Voltage Independent or Current Operated functionality and Voltage Dependent or Voltage Operated functionality.

A Voltage Dependant or Voltage Operated circuit protection device typically uses a residual current or differential current transformer. The residual current or differential current transformer often has a large internal diameter, or central aperture, in proportion to an outer diameter. The residual current transformer is only required to measure the differential current between conductors passing through the transformer and, therefore, it typically needs only a single primary turn for each such conductor (e.g. a Line In and Line Out conductor). An independently powered solenoid actuator is typically used as a means to trip a mechanism to open main contacts in the Voltage Dependent circuit protection and control device to break the electrical circuit.

A Voltage Independent or Current Operated circuit protection device typically uses a differential current transformer as a means for residual current measurement and as a means to provide sufficient energy to trip a relay. The relay, in turn, is configured to act on a mechanism to open main contacts of the Voltage Independent circuit protection device. As such, the Voltage Independent circuit protection device is current operated, which is a more accurate description of this type of device.

Typically the residual current transformers used in Voltage Independent or Current Operated circuit protection devices have significantly larger core cross-sectional areas and overall size when compared to residual current transformers typically used in Voltage Dependent circuit protection devices. This is due to the requirement for the residual current transformer of the Voltage Independent circuit protection device to be configured such that a sufficiently large current is induced in a secondary winding of the transformer, from the fault current, to trip the relay. Accordingly, multiple primary turns of the conductors (e.g. both the Line In and Line Out conductors) are required to pass through the central aperture of the residual current transformer in the Voltage Independent circuit protection device.

Published UK patent application GB2473014 describes a current sensor used to measure AC and DC current in an electrical network comprising a current transformer and resistive shunts connected in series with a plurality of line in conductors, said resistive shunts being located within the central aperture of the current transformer, and said resistive shunts and temperature sensors being located in an insulator housing which has a locating feature that aligns with a mating feature in the current transformer case.

The combined sensor described in GB2473014 can be applied to both Voltage Dependent and Voltage Independent circuit protection devices or, indeed, a circuit protection device having the combined Voltage Dependent and Voltage Independent functionality. However, it is primarily suited to Voltage Dependent applications due to the requirement in Voltage Independent circuit protection devices for multiple primary turns of the conductors (which therefore occupy a large proportion of the space in the central aperture of the residual current transformer thus restricting the space available for the resistive shunt(s)).

Embodiments of the present invention seek to ameliorate one or more problems associated with the prior art.

Accordingly, described herein are embodiments including improvements on previous devices. These improvements may include locating a resistive shunt on the outside diameter or the side face of a current transformer or current transformer case. This may allow further options for a combined current sensor whilst addressing one or more of the specific requirements of Voltage Independent circuit protection device applications.

We also describe further improvements on previous devices which may include locating a resistive shunt in series with either one or more Line In conductors or with a Line Out conductor. This further improvement option may enable benefits to the manufacture, design, complexity and cost of associated processing electronics and the combined current sensor.

Embodiments of the invention as described herein seek to enable a combined resistive shunt based current sensor and a current transformer, enabling AC and DC current to be determined. Thus, given a known resistance, the power measurement in a single phase or a plurality of phases of an electrical power supply can also be determined (all within the available space (i.e. volume) taken by a null balance AC current transformer, as is typically used for the measurement of residual / earth leakage / differential current). Embodiments of the present invention also seek to utilise the available space to maximise the rated current capacity and sensing functionality of the combined sensor, whilst minimising power loss due to heating.

According to an aspect of the invention we provide a device for measuring AC and DC current in an electrical network, the device comprising: a current transformer, and a resistive shunt connected in series with a line in conductor or a line out conductor, the resistive shunt being located on the current transformer or current transformer case.

Further features of the above aspects of the invention are described in the appended claims.

Said resistive shunt may be located on an outer diameter or outer surface or side surface of the current transformer or current transformer case.

The device may further include a line out conductor passing through a central aperture of the current transformer as a primary turn or a plurality of primary turns.

The device may further include a line in conductor passing through a central aperture of the current transformer as a primary turn or a plurality of primary turns.

The device may further include a current transformer case in which the current transformer is located.

The device may include a temperature sensor located within the current transformer case.

The current transformer case may be a whole or split toroidal current transformer case, or a split core or race track current transformer case.

The device may include a resistive shunt temperature sensor associated with the resistive shunt.

The resistive shunt may include at least a portion which has an arcuate cross-sectional shape which is located within a central aperture of the current transformer.

The resistive shunt may include at least a portion which has a rectangular cross-sectional shape which is located within a central aperture of the current transformer.

The resistive shunt may include at least a portion which has an arcuate cross-sectional shape which is located on an outer diameter or outer surface or side surface of the current transformer or current transformer case.

The resistive shunt may include at least a portion which has a rectangular cross-sectional shape which is located on an outer diameter or outer surface or side surface of the current transformer or current transformer case.

The current transformer may be a toroidal current transformer.

The current transformer may have an asymmetrical shape.

The current transformer may be a split core current transformer.

The resistive shunt may be mounted on an insulator housing which has a locating feature that aligns with a mating feature in a current transformer case.

Another aspect provides a combination of a device and calculating means, wherein the device is a device as above and the calculating means is operable to determine temperature, current, voltage, impedance, in series and parallel arc fault, power and energy.

The calculating means may be operable to calculate residual / earth leakage or differential current.

The calculating means may be further operable to determine a power in the line in conductor and an overall power of the electrical network.

The calculation means may be further operable to measure a temperature change across the resistive shunt and determine a temperature shift either side of a centre of the resistive shunt indicating an over temperature failure of a component, a device, a connection or a contact upstream or downstream of the resistive shunt.

The calculating means may be further operable to determine a local ambient temperature and use an algorithm to compensate a calculated current in both the current transformer and the resistive shunt.

The calculating means may be operable to determine the presence of a DC residual current using the device.

The calculating means may be operable to measure and detect current signatures.

The calculating means may be operable to detect a loss of a neutral or line out connection.

The calculating means may be operable to enable a reference voltage of the calculating means to be at the same potential as the resistive shunt.

The resistive shunt may be connected in series with the Line In conductor and the calculating means is powered from the Line In conductor.

The device may include a plurality of resistive shunts which are each connected in series with a respective Line In conductor and the calculating means is powered from any of the Line In conductors.

Embodiments of the invention are described herein, by way of example only, with reference to the following figures, in which:

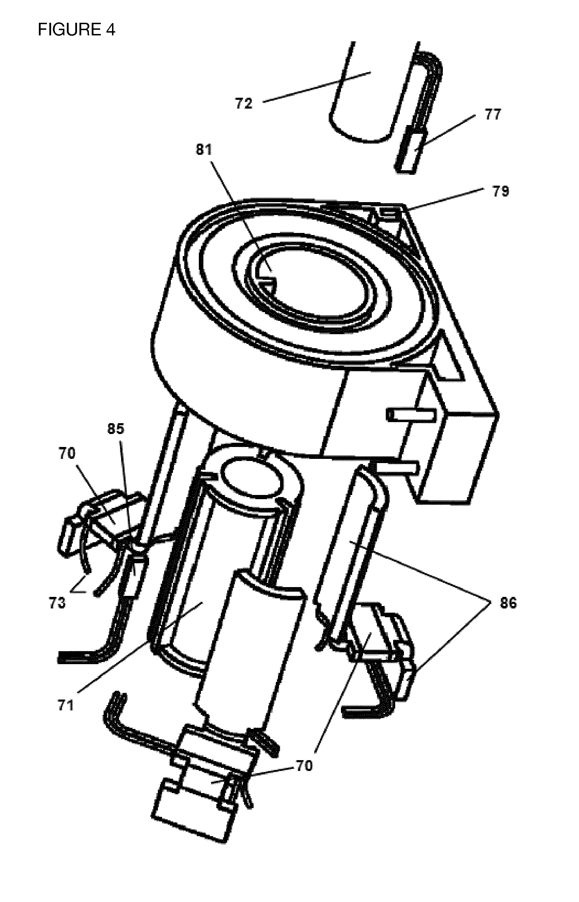

Figures 1, 2, 3 and 4 are diagrams of single or multi phase embodiments with a single resistive shunt for each phase Line In combined with a toroidal current transformer each resistive shunt located on a side face of the current transformer or current transformer case;
Figures 5 and 6 are diagrams of single, or multi-phase, multi-turn embodiments with a single resistive shunt in series with the phase Line Out combined with a toroidal current transformer, said resistive shunt being located on an outer diameter of the current transformer or current transformer case; and
Figures 7 and 8 are diagrams of single, or multi-phase, multi-turn embodiments with a single resistive shunt for each phase Line In combined with a toroidal current transformer, wherein each resistive shunt is located on an outer diameter of the current transformer or current transformer case.

It should be understood that the features defined in relation to each embodiment described herein are not intended to be exclusive to that particular embodiment unless it is stated otherwise. In other words, features of each embodiment are readily combinable with the other embodiments described, and can be applied in combination with the features of those other embodiments.

Embodiments of the devices described herein are capable of measuring both phase (or 'line') and differential currents. The combination of two different types of current sensor/transformer within a single unit minimises the space requirements that would otherwise be required to accommodate two separate sensors. The device of embodiments of the present invention occupies substantially the same volume as that typically required by a single current transformer, or at least within the volume of the current transformer case that would otherwise have housed a single transformer.

Embodiments may enable a resistive shunt based current sensor capable of measuring AC and DC current in a single phase, or a plurality of phases, to be combined with an existing (conventional) current transformer. This may maximise the rated current capability and functionality of the combined sensor in a given space.

Embodiments of the invention may include a current sensor used for measuring AC and DC current in an electrical network. The current sensor may comprise a current transformer, and one or more resistive shunts connected in series with a respective one or more Line In conductors and/or a respective one or more Line Out conductors. The resistive shunts are located on the current transformer or current transformer case. The resistive shunt or shunts may include respective resistive shunt terminals and temperature sensors which are mounted (or otherwise located) on or in an insulator housing which has a locating feature that is configured to align with a mating feature in a current transformer case (which houses the current transformer or a part thereof).

The one or more resistive shunts may be mounted (or otherwise located) on an outer circumference (i.e. diameter) and/or other outer surface(s) and/or side surface(s) of a current transformer or a current transformer case. The or each resistive shunt is connected in series with a respective Line In conductor (of which there may be a plurality) and/or in series with a respective Line Out conductor (of which there is typically one). Therefore, a current may be sensed in one or more Line In conductors which pass through the central aperture of the current transformer as a primary turn, or a plurality of primary turns, and/or in a Line Out conductor passing through the central aperture of the current transformer as a primary turn, or a plurality of primary turns.

Current flowing in each conductor may be calculated by measuring a voltage drop across each respective resistive shunt (using shunt sense connections associated with each resistive shunt). A calculation device or arrangement (or other means) may be provided and this may be an electronic circuit or computer algorithm implemented on a processor.

The resultant AC and DC current measurement in each conductor may be processed by suitable processing electronics of the calculation means to calculate residual/earth leakage or differential current and determine the temperature, current, voltage, impedance, power and/or energy associated with each conductor and the overall power associated with a plurality of conductors.

As will be appreciated, in a multi-phase supply, there may be one conductor for each phase and a neutral conductor. Such a supply may be a three phase supply and may, therefore, use four conductors.

In some embodiments, further processing of the measurements from the combined current sensor, by suitable processing electronics (or other part of the calculation means), can calculate and determine series and parallel arc fault conditions. The calculation means may be configured to identify arc fault conditions.

In some embodiments, further processing of the measurements from one or more of the resistive shunts, and monitoring of the null balance current using the current transformer, may enable both differential AC and DC current measurement (in the same space (i.e. volume)) by using suitable processing electronics. This may thus enable the presence of a DC residual current to be detected.

In some embodiments, the or each resistive shunt has a respective resistive shunt terminal. The size of the resistive shunt terminal may depend on the current rating of the device (i.e. the terminal has a scalable cross-sectional shape to enable maximum usage of the available cross-sectional area in a given current transformer aperture to maximise the rated current capability).

Thus the resistive shunt terminal, in some embodiments, may have an arcuate cross-sectional shape through a plane perpendicular to a longitudinal axis of the terminal and may be configured to be located, at least partially, within a central aperture of the transformer case. The current transformer case may be a whole or split toroidal transformer case. The resistive shunt terminal may have a rectangular cross-section through the aforementioned plane and may be configured to be located within the central aperture of the transformer case. In such embodiments, the current transformer case may be a split core or race track current transformer case.

The use of resistive shunt sensors may enable a high degree of AC and DC current measurement accuracy over a wide ambient temperature range. Embodiments of the present invention may also include a local ambient temperature sensor located within the current transformer case. The local ambient temperature sensor may be coupled to suitable processing electronics (e.g. of the calculation means) which may be operable to determine a local ambient temperature for the transformer.

The calculation means may be configured to use an algorithm operable to compensate for the local ambient temperature when determining the current in both or either of the current transformer or the resistive shunt.

In some embodiments, a resistive shunt temperature sensor is provided in association with the or each resistive shunt. In some embodiments, the resistive shunt temperature sensor associated with a resistive shunt is mounted on the resistive shunt. In some embodiments, the resistive shunt temperature sensor is located generally centrally along a length of the associated resistive shunt (the length being defined between terminals of the resistive shunt which permit connection to a Line In or Line Out conductor). In some embodiments, the resistive shunt temperature sensor is located at an axial midpoint of the associated resistive shunt.

In some embodiments, the local ambient temperature sensor and/or the or each resistive shunt temperature sensor is used to enable active temperature compensation of the measured current in each conductor.

In some embodiments, the or each resistive shunt temperature sensor can be used (e.g. by the use of suitable processing electronics (which may be part of the calculating means) coupled thereto) to measure a temperature change at a central location along the length the associated resistive shunt (i.e. the axial midpoint of the resistive shunt) to determine a temperature shift either side of the central location (i.e. the axial central location) of the resistive shunt. This may be used to identify an indication of an over-temperature failure of a component, a device, a connection, or a contact upstream or downstream of the resistive shunt.

In some embodiments, the use of both one or more resistive shunts and a current transformer, when coupled to a suitable calculating means (such as processing electronics), allows the measurement and detection of current signatures. These may be used to detect further electrical faults or the behaviour of an electrical component or system.

As will be appreciated, embodiments of the present invention provide a combined sensor which can be further described as a combination of resistive shunt and current transformer (wherein the current transformer may be a toroidal type, split core type of either symmetrical or a non-symmetrical shape).

According to embodiments, there is an option of placing the resistive shunt in series with either a Line In conductor or a Line Out conductor when combined with a current transformer or current transformer case as a combined current sensor. This provides additional benefits to maximise the functionality and available space which can be achieved.

In some embodiments, having the resistive shunt in series with the Line in or plurality of Line in conductors or the Line Out conductor, when coupled to calculation means in the form of processing electronics, enables a reference voltage of the electronics to be at the same potential as the resistive shunt (and resistive shunt sense connections). This enables a reduction in power supply components and a further maximising of the available space in the device of embodiments of the invention.

A further benefit of the resistive shunt being in series with the Line Out conductor, in some embodiments, (and particularly in a multi-phase application of the combined sensor) is, when coupled to calculation means in the form of processing electronics, the resistive shunt can be used to measure the overall current, voltage, power and energy.

A further benefit of the resistive shunt in series with the Line Out conductor, in some embodiments, is, when coupled to calculation means in the form of processing electronics, the loss of the neutral or Line Out conductor connection can be detected.

A benefit of having the resistive shunt in series with the Line In conductor, or plurality of Line In conductors, is, when coupled to calculating means in the form of processing electronics, electrical fault conditions can be more reliably detected and maintained even in a loss of neutral (i.e. Line Out) fault condition when the current path may flow to earth (if a functional earth connection is available).

A further benefit of having the resistive shunts in series with the Line In conductor, or plurality of Line In conductors, is, when coupled to calculating means in the form of processing electronics, said processing electronics can be powered from any of the Line In conductors.

According to a possible combination of embodiments, a combined sensor may have a resistive shunt in series with the Line Out conductor and a current transformer with a Line In conductor (and perhaps not the Line Out conductor) passing through the central aperture; thus both the resistive shunt and the current transformer can, when coupled to calculating means in the form of processing electronics, be used to measure Line In and Line Out current. Such embodiments could be used, for example, for series and parallel arc fault detection, residual current, power and energy measurement.

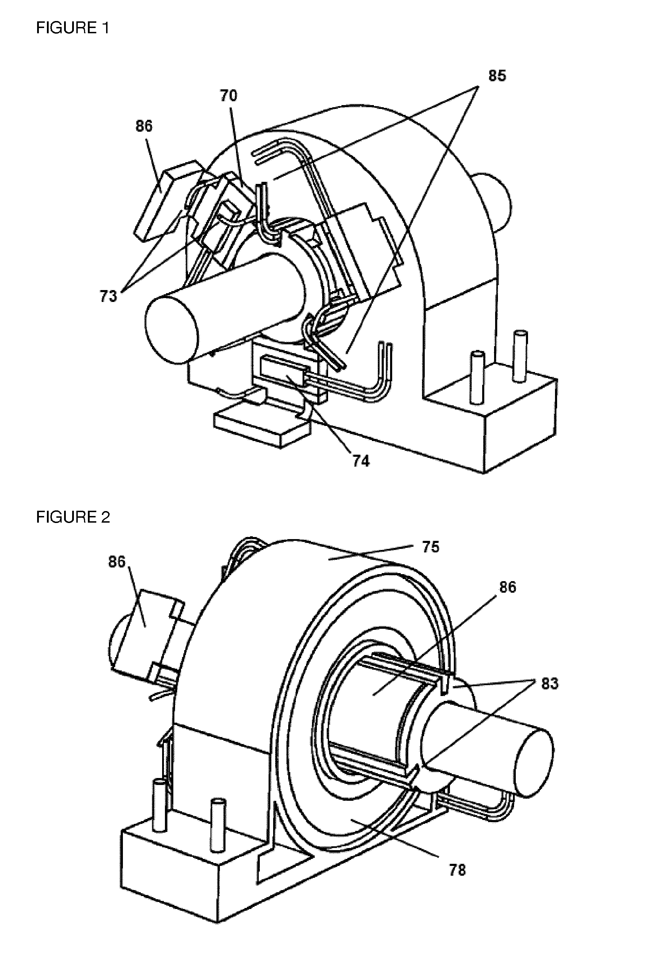

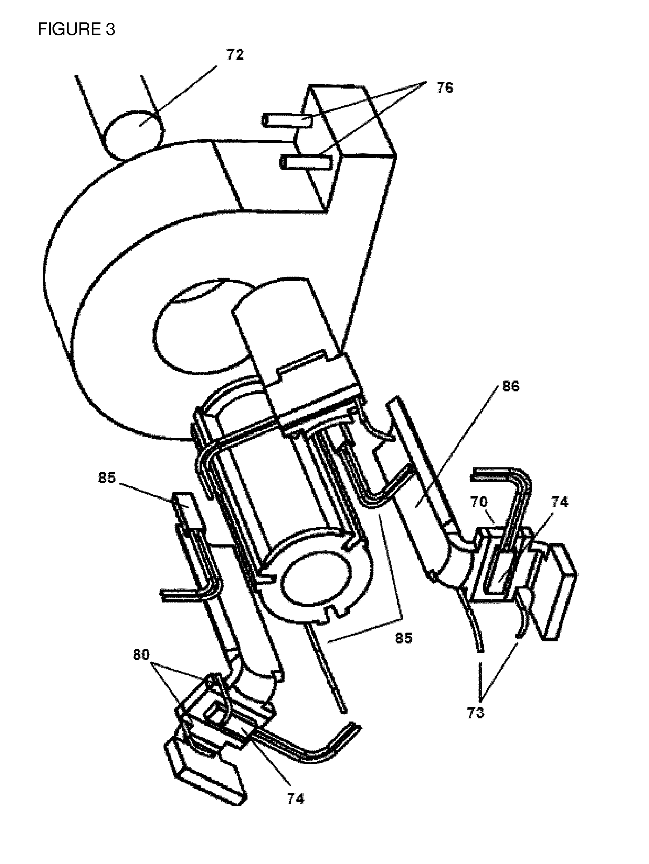

Figure 1, 2 & 3 show an embodiment of the invention. The embodiment includes a device for measuring AC and DC current in an electrical network (or circuit). The device may be what is described herein as a combined sensor.

The device includes a current transformer 78 which may be of a form described herein (e.g. toroidal). The current transformer 78 has an outer circumferential part and an inner circumferential part. The inner circumferential part defines a central aperture of the current transformer 78. The current transformer 78 also has two opposing side faces which oppose each other across a depth of the current transformer 78. As will be appreciated, the outer perimeter of the current transformer 78 may not, in some embodiments, be circular and could be oval, for example. References to the outer circumferential part, as made herein, are references to the outer perimeter part of the current transformer 78 irrespective of its shape.

The current transformer 78 is, in embodiments, housed in a current transformer case 75. As will be appreciated, the current transformer case 75 may have a form which generally corresponds with that of the current transformer 78 such that the current transformer case 75 has an outer circumferential part and an inner circumferential part (the inner circumferential part defining a central aperture of the current transformer case 75). The current transformer case 75 also has two opposing side faces which oppose each other across a depth of the current transformer case 75.

As will be appreciated, the two side faces of the current transformer 78 and current transformer case 75 may be said to extend in a direction which is parallel to a radius or diameter of the current transformer 78 or current transformer case 75, as the case may be.

The device includes one or more resistive shunts 70 and may have a plurality of resistive shunts 70. The or each resistive shunt 70 may be located on a respective one of the two side faces of a current transformer 78 or current transformer case 75.

The or each resistive shunt 70 may be mounted with respect to an insulator 71. The insulator 71 may be an annular member which is configured to be at least partially received within the central aperture of the current transformer 78 and/or current transformer case 78.

The or each resistive shunt 70 may be mounted (or otherwise assembled) such that they are located around at least a portion of a curved outer surface of the insulator 71. In other words, the or each resistive shunt 70 may be mounted such that it is positioned around at least part of an outer circumferential surface of the insulator (i.e. radially with respect to the insulator 71).

The insulator 71 and one or more resistive shunts 70 form a sub-assembly which is configured to be in located within the central aperture of the current transformer case 75 and/or current transformer 78 (e.g. such that the insulator 71 and current transformer case 75 and/or current transformer 78 are co-axial (i.e. axially located within the central aperture of the current transformer case 75)).

The insulator 71 may include one or more locating features at least one of which is configured to engage a respective locating feature 81 of the current transformer case 75 (or current transformer 78). The locating feature or features of the insulator 71 may also define a spacing for a plurality of the resistive shunts 70 in some embodiments. The spacing may be such that the resistive shunts 70 are substantially evenly spaced around the insulator 71.

In some embodiments the insulator 71 is configured such that resistive shunt sense points 80 associated with each resistive shunt 70 are substantially evenly (i.e. equally) placed around one of the side faces of the current transformer case 75 and/or the current transformer 78.

The resistive shunt sense points 80 are the parts of each resistive shunt 70 between which a member of known resistance is mounted or otherwise located.

The or each resistive shunt 70 is also provided with a respective plurality of resistive shunt sense wires 73. Each resistive shunt sense wire 73 is coupled in electrical communication with a respective resistive shunt sense point 80 of a resistive shunt 70. In embodiments, each resistive shunt 70 has two resistive shunt sense points 80 and two resistive shunt sense wires 73.

The or each resistive shunt 70 is associated with a resistive shunt temperature sensor 74. In some embodiments, therefore, a plurality of resistive shunt temperature sensors 74 may be provided. Each resistive shunt temperature sensor 74 may be mounted to a resistive shunt 70. The mounting may be such that the resistive shunt 70 is located at a generally central position along a length of the resistive shunt 70 (which may be a generally central position between the two shunt sense points 80 of the resistive shunt 70). The or each resistive shunt temperature sensor 74 may comprise an elongate member which is mounted such that its longitudinal axis is perpendicular to an axis along a length between the two shunt sense points 80. In some embodiments, the or each resistive shunt temperature sensor 74 may be located at the axial centre of a respective one of the resistive shunts 70.

One or more (and possibly a plurality of) resistive shunt terminal temperature sensors 85 may be provided which are configured to be mounted to the insulator 71. In some embodiments, the or each resistive shunt terminal temperature sensor 85 is configured to be mounted in the insulator 71 (which may be such that the or each resistive shunt terminal temperature sensor 85 is located in a respective one of a plurality of locating grooves 83 of the insulator 71 (the grooves being examples of locating features). The or each resistive shunt terminal temperature sensor 85 may be an elongate member with a longitudinal axis which is generally aligned with a longitudinal axis of the insulator 71 (i.e. placed axially). The or each resistive shunt terminal temperature sensor 85 may be associated with and located on a respective one of the or each of the plurality of resistive shunt terminals 86.

In embodiments, an ambient temperature sensor 77 is provided (i.e. a local ambient temperature sensor). The ambient temperature sensor 77 may be mounted (or otherwise located) in the current transformer case 75 (e.g. at a location 79 in the current transformer case 75).

In embodiments, a Line Out (or neutral) conductor 72 having a form such that it is at least partially receivable within the annular insulator 71 (e.g. it has a cross-sectional shape suitable such that the Line Our conductor 72, the or each resistive shunts 70 and the insulator 71 can be assembled (i.e. fitted) within the central aperture of the current transformer 78 and/or current transformer case 75. The Line Out conductor 72 may be configured to be axially received through the centre aperture of the insulator 71.

One or more Line In conductors (not shown) may be fixed in electrical communication with respective ones of the resistive shunts 70. In other words, the or each resistive shunt 70 is configured to be connected in series with one or more respective Line In conductors.

Current transformer contact pins 76 (at least two) may be provided. The current transformer contact pins 76 are coupled to respective ends of a secondary winding of the current transformer 78 and the secondary winding may be housed within the current transformer case 75. The current transformer contact pins 76 may extend from a part of the current transformer case 75.

The secondary winding (via the current transformer contact pins 76), the plurality of resistive shunt sense wires 73, the or each resistive shunt temperature sensors 74, the or each resistive shunt terminal temperature sensors 85, and the ambient temperature sensor 77 may, in some embodiments, be connectable to a suitable calculation means which may be in the form of an electrical circuit and processing electronics. The calculation means is configured to perform one or more operations on the sensed (i.e. measured) information and to take one or more actions in the event of an incident being detected or to analyse the behaviour of one or more pieces of equipment powered through the Line In and Line Out conductors.

The current passing through the or each resistive shunt 70 (the Line In current associated with the Line In conductor coupled to that resistive shunt 70) and the current passing through the Line Out conductor 72 (i.e. the Line Out current) can be monitored by the calculation means (e.g. processing electronics) using the current transformer 78 and secondary winding (accessed via the transformer contact pins 76) to determine if there is an imbalance of the nulling current induced in the current transformer 78.

The current passing through the or each of the Line In conductors (fixed respective resistive shunts 70) can be measured by using a voltage drop across a respective resistive shunt 70 via the sense points 80 using the resistive shunt sense wires 73.

The or each resistive shunt 70, having a known resistance for a given temperature, allows the calculation means to calculate the Line In current for a given Line In conductor using the sensed temperature for the associated resistive shunt 70 and voltage drop across the resistive shunt 70. This can be used to determine the power passing through that Line In conductor (which may be a phase of a multi-phase power supply).

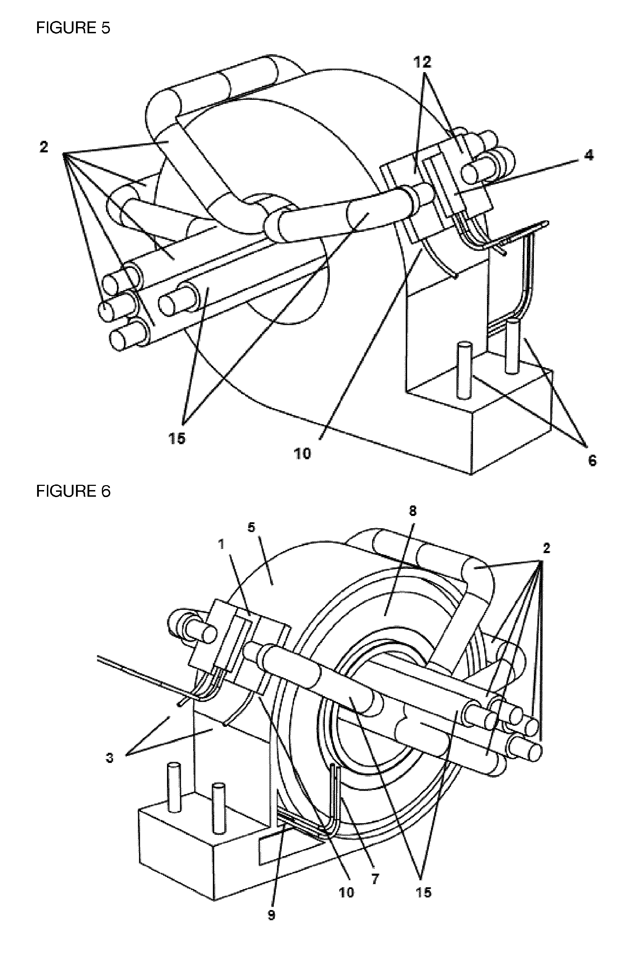

Figures 5 to 8 show further embodiments. In these embodiments, there are provided one or more of resistive shunts 1 which are mounted (or otherwise located) on the outer circumferential part of the current transformer 8 or current transformer case 5 (i.e. 'on a diameter' or 'on an outer diameter' of the current transformer 8 or current transformer case 5).

The Line Out conductor 15 (see figures 5 and 6 in particular) and the Line In conductors 2 (of which there may be one or more) may have multiple turns passing through the central aperture of the current transformer 8 (i.e. such that they form multiple primary windings).

The Line Out conductor 15 and one or more Line In conductors 2 extend through the central aperture of the current transformer 8 and current transformer case 5 and may be located towards a central axis of the central aperture (i.e. the conductors 15, 2 may form a sub-assembly which is located axially within the central aperture of the current transformer case 5 and/or current transformer 8).

The resistive shunt sense wires 3 are connected to the resistive shunt sense points 10 - generally as described herein. The or each resistive shunt temperature sensor 4 may be mounted (or otherwise located) with respect to its associated resistive shunt 1 generally as described herein (e.g. at the axial centre of the respective resistive shunt 1).

The ambient temperature sensor 7 is located in the current transformer case 5 at the location 9 (generally as herein described).

The Line Out conductor 15 may, in some embodiments, be coupled in series with the resistive shunt 1 (i.e. fixed either side of the resistive shunt 1 at the resistive shunt sense points 10 (which may include fixing locations)).

As with the other embodiments, the current transformer contact pins 6 are coupled to a secondary winding of the current transformer 8.

In some embodiments, the current transformer contact pins 6, the resistive shunt sense wires 3, the resistive shunt temperature sensor 4, and the ambient temperature sensor 7 are all connected to a suitable calculating means (such as an electrical circuit & processing electronics).

The Line In current passing through the Line In conductor 2 (or plurality of Line In conductors 2) can be monitored by using the secondary winding via the current transformer contact pins 6.

The Line Out current passing through the resistive shunt 1, the Line In current passing through the Line In conductor 2 (or plurality of Line In conductors 2) can be monitored by the calculating means (such as processing electronics) to determine if there is an imbalance of the nulling current induced in the current transformer 8.

As discussed herein, the current in the Line Out conductor 15 fixed to the resistive shunt 1 can be measured by taking a voltage drop across the resistive shunt 1 at the resistive shunt sense points 10 (using the resistive shunt sense wires 3).

The resistive shunt 1 has a known resistance for a given temperature and this allows the calculating means (e.g. the processing electronics) to calculate the current using the temperature and voltage drop. The calculating means may also determine the power using a suitable algorithm.

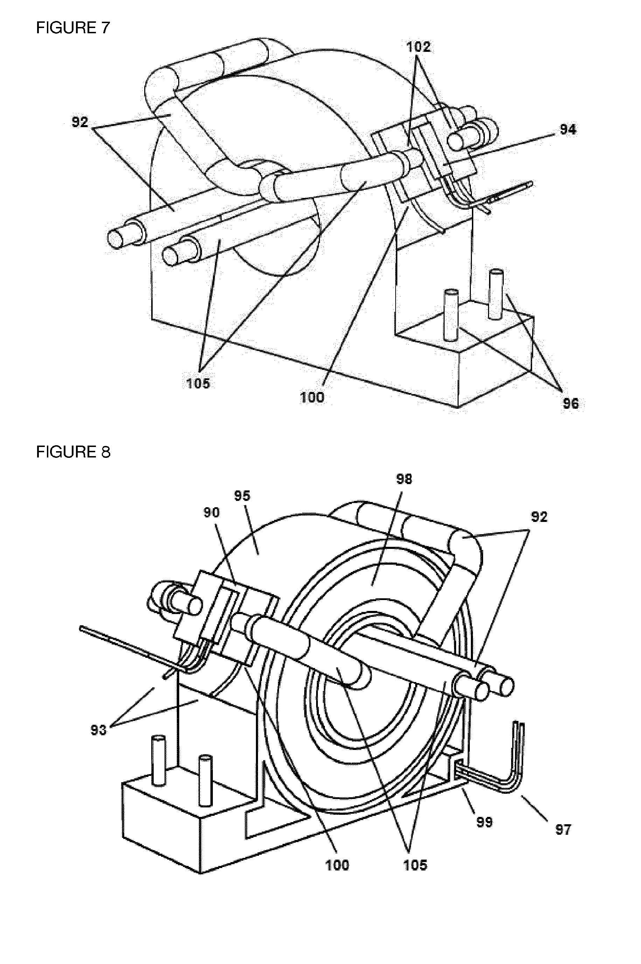

Figures 7 and 8 show a further embodiment having a single or plurality of resistive shunts 90.

The or each resistive shunt 90 may be mounted (or otherwise located) on the outer circumferential part of the current transformer 98 or current transformer case 95 (i.e. 'on a diameter' or 'on an outer diameter') of the current transformer 98 or current transformer case 95).

There may be one or more Line In conductors 105. The or each Line In 105 and the or each Line Out conductor 92 may have multiple turns forming a primary winding of the current transformer 98 and pass through the central aperture of the current transformer 98 and/or the current transformer case 95.

The Line In and Line Out conductors 92,105 form a sub-assembly which may be positioned, at least in part, towards a central axis of the central aperture of the current transformer 98 or current transformer case 95 (i.e. located axially within the central aperture of the current transformer case 95 or current transformer 98).

Again, a plurality of resistive shunt sense wires 93 are connected to a respective plurality of resistive shunt sense points 100. A resistive shunt temperature sensor 94 may be provided for each resistive shunt 90. The resistive shunt temperature sensor 94 may be generally located as described above in relation to other embodiments (e.g. can be located at an axial centre of the resistive shunt 90). An ambient temperature sensor 97 is provided at a location 99 in the current transformer case 95.

The Line In conductor or conductors 105 may, in embodiments, be coupled to respective resistive shunts 90 (i.e. may be fixed either side of the resistive shunt 90 at the resistive shunt sense points 102 (which may include fixing locations).

A secondary winding may be provided which is coupled to current transformer contact pins 96 (generally as described herein).

The secondary winding (via the current transformer contact pins 96), the plurality of resistive shunt sense wires 93, the plurality of resistive shunt temperature sensors 94, and the ambient temperature sensor 97 may all be connected to a suitable calculation means (e.g. electrical circuit & processing electronics).

The Line Out current can be determined using the secondary winding (accessed via the current transformer contact pins 96).

The respective Line In currents passing through the or each resistive shunt 90 and the Line Out current passing through the Line Out (i.e. neutral) conductor 92 can be monitored by the calculating means (e.g. processing electronics) to determine if there is an imbalance of the nulling current induced in the current transformer 98.

The current in the or each Line In conductor 105 coupled (or otherwise fixed) to the or each resistive shunt 90 can be measured by taking a voltage drop across the resistive shunt 90 at the sense points 100 using the resistive shunt sense wires 93. The resistive shunt 90 has a known resistance for a predetermined temperature and this allows the calculating means to calculate the Line In current from the temperature and voltage drop associated with the or each resistive shunt 90. A power of each of the Line In conductors (which may be a phase power in a multi-phase power supply) can be calculated using a suitable algorithm.

Embodiments include a combination of the device and calculating means.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. A device for measuring AC and DC current in an electrical network, the device comprising:
a current transformer, and
a resistive shunt connected in series with a line in conductor or a line out conductor, the resistive shunt being located on the current transformer or current transformer case.

2. A device according to claim 1, wherein said resistive shunt is located on an outer diameter or outer surface or side surface of the current transformer or current transformer case;
AND/OR
further including a line out conductor passing through a central aperture of the current transformer as a primary turn or a plurality of primary turns;
AND/OR
further including a line in conductor passing through a central aperture of the current transformer as a primary turn or a plurality of primary turns.

3. A device according to any preceding claim, further including a current transformer case in which the current transformer is located.

4. A device according to claim 3, including a temperature sensor located within the current transformer case

5. A device according to claim 3 or 4, wherein the current transformer case is a whole or split toroidal current transformer case, or a split core or race track current transformer case.

6. A device according to any preceding claim, including a resistive shunt temperature sensor associated with the resistive shunt.

7. A device according to any preceding claim, wherein the resistive shunt includes:
at least a portion which has an arcuate cross-sectional shape which is located within a central aperture of the current transformer;
OR at least a portion which has an arcuate cross-sectional shape which is located on an outer diameter or outer surface or side surface of the current transformer or current transformer case;
OR at least a portion which has a rectangular cross-sectional shape which is located within a central aperture of the current transformer;
OR at least a portion which has a rectangular cross-sectional shape which is located on an outer diameter or outer surface or side surface of the current transformer or current transformer case.

8. A device according to any preceding claim, wherein the current transformer is a toroidal current transformer;
OR
the current transformer has an asymmetrical shape.

9. A device according to any preceding claim, wherein the current transformer is a split core current transformer;
AND/OR
wherein the resistive shunt is mounted on an insulator housing which has a locating feature that aligns with a mating feature in a current transformer case.

10. A combination of a device and calculating means, wherein the device is a device according to any preceding claim and the calculating means is operable to determine temperature, current, voltage, impedance, in series and parallel arc fault, power and energy.

11. A combination according to claim 10, wherein the calculating means is operable to calculate residual / earth leakage or differential current;
AND/OR
the calculating means is further operable to determine a power in the line in conductor and an overall power of the electrical network.

12. A combination according to any of claims 10 or 11, where dependent directly or indirectly on claim 6, wherein the calculating means is further operable to measure a temperature change across the resistive shunt and determine a temperature shift either side of a centre of the resistive shunt indicating an over temperature failure of a component, a device, a connection or a contact upstream or downstream of the resistive shunt.

13. A combination according to any of claims 10 to 12, where dependent directly or indirectly on claim 4, wherein the calculating means is further operable to determine a local ambient temperature and use an algorithm to compensate a calculated current in both the current transformer and the resistive shunt.

14. A combination according to any of claims 10 to 13, wherein the calculating means is operable to do at least one of:
- determine the presence of a DC residual current using the device;
- measure and detect current signatures;
- detect a loss of a neutral or line out connection;
- enable a reference voltage of the calculating means to be at the same potential as the resistive shunt.

15. A combination according to any of claims 10 to 14, wherein the resistive shunt is connected in series with the Line In conductor and the calculating means is powered from the Line In conductor;
OR
wherein the device includes a plurality of resistive shunts which are each connected in series with a respective Line In conductor and the calculating means is powered from any of the Line In conductors.
